# EUROPEAN PATENT SPECIFICATION

(11) **EP 2 511 985 B1**
(45) Date of publication and mention of the grant of the patent: **13.01.2016**
(21) Application number: 12001834.6
(22) Date of filing: 19.03.2012
(51) Int. Cl.: H01R 12/70, H05K 3/34, H01R 12/50

(54) **Board connector and method of producing a fixing member therefor**
Leiterplattensteckverbinder und Verfahren zur Herstellung eines Befestigungsmittels dafür
Connecteur de carte et procédé de production d'un élément de fixation correspondant

(30) Priority: 12.04.2011 JP 2011088273
(43) Date of publication of application: 17.10.2012
(73) Proprietor: Sumitomo Wiring Systems, Ltd., Yokkaichi-city, Mie 510-8503 (JP)
(72) Inventor: Aihara, Tetsuya, Yokkaichi-City Mie 510-8503 (JP)
(74) Representative: Müller-Boré & Partner Patentanwälte PartG mbB

(56) References cited:
- EP-A1- 1 993 172
- EP-A1- 2 453 530
- US-A- 4 027 521
- US-A1- 2008 085 616
- US-B1- 6 454 599

## Description

The present invention relates to a board connector and to a method of producing a fixing member therefor.

A board connector disclosed in Japanese Unexamined Patent Publication No. 2008-53025 is to be mounted on a surface of a printed circuit board (hereinafter, merely referred to as a board) and includes a connector housing made of synthetic resin and a pair of fixing members made of metal. A plurality of terminal fittings are mounted in the connector housing, and ends of the respective terminal fittings are solder-connected to conductive portions of the board. Each fixing member is composed of a housing mounting portion which is mounted by being press-fitted onto one of both side surfaces of the connector housing and a board mounting portion which is mounted by being soldered to the surface of the board. The housing mounting portions are arranged along a height direction parallel to the both side surfaces of the connector housing and the board mounting portions are arranged along a horizontal direction parallel to the surface of the board. Further, a pair of front and rear mounting grooves are formed in each of the both side surfaces of the connector housing to extend in the height direction, and both front and rear ends of the housing mounting portion are inserted and held in the mounting grooves of the connector housing. The connector housing is fixed to the board via the fixing members by mounting the housing mounting portions onto the connector housing and mounting the board mounting portions on the board.

If an external force acts on the board connector in a mounted state in a direction to tear the board connector from the board when the fixing members have low rigidity, the fixing members may be plastically deformed to reduce insertion margins of the housing mounting portions into the mounting grooves. As a result, reliability in holding the fixing members onto the connector housing may be reduced. Even if the fixing member is provided with a rib for reinforcement to cope with this problem, one rib is insufficient and a plurality of ribs have to be provided. This leads to difficulty in ensuring a space for a necessary number of ribs for the fixing members.

Document US 6,454,599 discloses a connector including a housing, a plurality of electrical contacts and a pair of grounding bridges. A pair of mounting channels is defined in two ends of the housing. The grounding bridges each comprise a first leg portion interferingly engaging into the channel.

Document EP 1 993 172 describes a fixer for connecting an object, such as a surface mount electrical connector, onto a circuit board. The fixer comprises a fastening part that is fastened to a side surface of the object. The fastening part is provided with holding parts that hold the object.

Another board connector is described in US 2008/0085616.

The present invention was completed in view of the above situation and an object thereof is to provide a board connector including a fixing member having high holding reliability and good space efficiency.

This object is solved according to the invention by the features of the independent claims. Particular embodiments of the invention are subject of the dependent claims.

According to one aspect of the invention, there is provided a board connector, comprising: a connector housing in which one or more terminal fittings connectable to one or more respective conductive portions of a board are to be mounted; and at least one fixing member is to fix the connector housing to the board; wherein: the fixing member includes a housing mounting portion to be mounted on a wall surface of the connector housing; and the housing mounting portion is formed with at least one first rib and at least one second rib respectively projecting while extending in forward and backward directions and the second rib is arranged to fit within the height range of the first rib with respect to a height direction perpendicular to forward and backward directions, wherein the first and second ribs respectively project in opposite directions.

Since the housing mounting portion is formed with the first and second ribs substantially extending in forward and backward directions, it is prevented from being plastically deformed even if an external force acts in a direction to tear or shift the

board connector from the board. Accordingly, reliability in holding the fixing member onto the connector housing is improved. Further, since the second rib is arranged to fit within the height range of the first rib with respect to the height direction perpendicular to the forward and backward directions, the enlargement of the housing mounting portion in the height direction is prevented and the space efficiency of the housing mounting portion and consequently the fixing member is improved.

According to a particular embodiment, the connector housing is made of resin and/or wherein the at least one fixing member is made of metal.

Particularly, both front and rear end portions of the housing mounting portion are at least partly inserted and held in mounting grooves formed in the wall surface of the connector housing.

According to a further particular embodiment, there is provided a board connector, comprising a connector housing which is made of resin and in which terminal fittings connectable to conductive portions of a board are to be mounted; and a fixing member which is made of metal and fixes the connector housing to the board; wherein the fixing member includes a housing mounting portion to be mounted on a wall surface of the connector housing and both front and rear end portions of the housing mounting portion are inserted and held in mounting grooves formed in the wall surface of the connector housing; and the housing mounting portion is formed with a first and a second ribs respectively projecting while extending in forward and backward directions and the second rib is arranged to fit within the height range of the first rib with respect to a height direction perpendicular to forward and backward directions.

Since the housing mounting portion is formed with the first and second ribs extending in forward and backward directions, it is prevented from being plastically deformed even if an external force acts in a direction to tear the board connector from the board. Accordingly, reliability in holding the fixing member onto the connector housing is improved. Further, since the second rib is arranged to fit within the height range of the first rib with respect to the height direction perpendicular to the forward and backward directions, the enlargement of the housing mounting portion in the height direction is prevented and the space efficiency of the housing mounting portion and consequently the fixing member is improved.

Particularly, the second rib is formed within the formation range of the first rib.

Further particularly, the first and second ribs respectively project in substantially opposite directions.

Further particularly, the second rib is formed within the formation range of the first rib and the first and second ribs respectively project in opposite directions.

Since the second rib is formed within the formation range of the first rib and the first and second ribs respectively project in the opposite directions, the enlargement of the housing mounting portion in the projecting direction of the first rib is prevented.

Particularly, the first rib projects outwardly away from the wall surface of the connector housing, the second rib projects inwardly toward the wall surface of the connector housing.

Further particularly, the second rib is arranged to fit within the projecting distance of the first rib.

Still further particularly, the first rib projects outwardly away from the wall surface of the connector housing, the second rib projects inwardly toward the wall surface of the connector housing and the second rib is arranged to fit within the projecting distance of the first rib.

Since the first rib projects outwardly away from the wall surface of the connector housing, the second rib projects inwardly toward the wall surface of the connector housing and the second rib is arranged to fit within the projecting distance of the first rib, the interference of the first and second ribs with the connector housing is avoided even without providing the wall surface of the connector housing with a recess or the like for allowing the first and second ribs to escape.

Particularly, the second rib is formed in a central part of the first rib in the height direction.

Since the second rib is formed in the central part of the first rib in the height direction, both the first and second ribs are excellent in shape stability.

Further particularly, a length of the second rib in forward and backward directions is substantially equal to that of the first rib in forward and backward directions and/or wherein a projecting distance of the second rib is shorter than that of the first rib.

Still further particularly, the first rib includes one or more, particularly a pair of division beads adjacent to the second rib, particularly on the substantially opposite sides of the second rib, wherein the both division beads particularly are substantially symmetrically shaped with respect to the second rib.

Further particularly, the fixing member comprises a board mounting portion to be mounted onto the board, wherein at least one slit 63A is so formed in at least one intermediate position of the board mounting portion in forward and backward directions, particularly so as to extend also in a lower end portion of the housing mounting portion, and/or wherein the board mounting portion is formed with one or more through holes and/or one or more cutout grooves, particularly so that with the board mounting portion placed on the board, solder can at least partly enter the respective through hole(s) and/or the respective cutout groove(s).

Still further particularly, the fixing member comprises one or more locking pieces and/or one or more sharp biting projections so as to fixedly mount the fixing member to the connector housing.

According to a further aspect of the invention, there is provided a method of producing or forming or press-forming a fixing member for fixing a board connector, in particular according to the above aspect of the invention or a particular embodiment thereof, to a board, comprising the following steps: shaping (e.g. cutting or stamping) a metal blank so as to form a housing mounting portion to be mounted to a connector housing of the board connector, placing a portion of the housing mounting portion on a forming surface of a projection of a first mold, relatively moving the first mold and a second mold to form a first rib body of a first rib between a recess of the second mold and the projection of the first mold, relatively moving the first and second molds to retract the first rib body from the second mold, lowering a pressing mold to press a pressing surface of the pressing mold into contact with at least one central or intermediate part of the first rib body so as to curve and deform an outer surface of the central or intermediate part of the first rib body along the pressing surface of the pressing mold, whereby at least the first rib and a second rib being arranged to fit within the height range of the first rib with respect to a height direction are formed, wherein the first and second ribs respectively project in opposite directions.

According to a particular embodiment, the first rib is formed with one or more, particularly a pair of division beads adjacent to the second rib, particularly on the substantially opposite sides of the second rib, wherein the both division beads particularly are substantially symmetrically shaped with respect to the second rib.

Particularly, when the outer surface of the central or intermediate part of the first rib body is curved and deformed along the pressing surface of the pressing mold, the both division beads of the first rib are formed.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view of a board connector according to one embodiment of the present invention,
FIG. 2 is a perspective view of a fixing member,
FIG. 3 is a side view of the fixing member,
FIG. 4 is a section along A-A of FIG. 3,
FIG. 5 is a section showing a state immediately after a first rib is formed, and
FIG. 6 is a section showing a state immediately after a second rib is formed.

### <Embodiment>

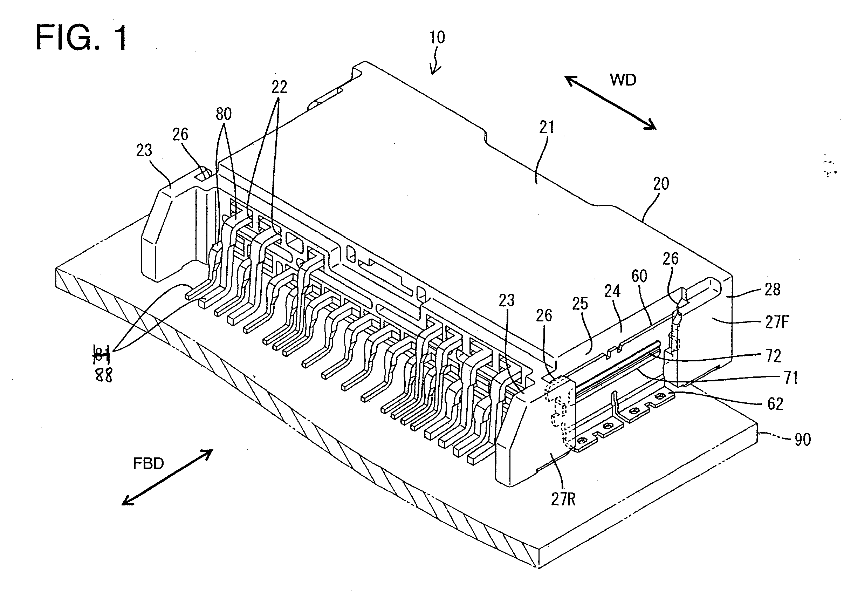

Hereinafter, one specific embodiment of the present invention is described with reference to FIGS. 1 to 6. As shown in FIG. 1, a board connector 10 according to this embodiment particularly is of a surface mounting type to be mounted on a surface of a printed circuit board (hereinafter, merely referred to as a board 90) and includes one or more terminal fittings 80, a connector housing 20 and one or more fixing members 60. The connector housing 20 is connectable to an unillustrated mating connector. Note that, in the following description, a side to be connected to the mating connector is referred to as a front side concerning forward and backward directions FBD.

Each terminal fitting 80 particularly is made of conductive (particularly metal) material and/or in the form of a (particularly substantially rectangular or polygonal) bar bent substantially in an S or Z shape and an intermediate part thereof is press-fitted and held in the back wall of a receptacle 21 to be described later as shown in FIG. 1. A front end portion of the terminal fitting 80 is arranged to project into the receptacle 21 and electrically connected to an unillustrated mating terminal fitting mounted in the mating connector at the time of connection to the mating connector. Further, a rear end portion of the terminal fitting 80 includes a board contact portion 88 which is arranged to be exposed outside the receptacle 21 and to be held in contact with the surface or a portion of the board 90. The board contact portion 88 particularly is to be solder-connected to the surface of the board 90, thereby being electrically connected to a conductive portion of the board 90.

The connector housing 20 is made e.g. of synthetic resin and includes the receptacle 21 (particularly substantially in the form of a flat rectangular tube long in a width direction WD) as shown in FIG. 1. The back wall of the receptacle 21 is formed with one or more, particularly a plurality of penetrating terminal mounting holes 22 into which the one or more respective terminal fittings 80 at least partly are to be inserted or press-fitted.

One or more, particularly a pair of protection walls 23 are formed to project backward from rear end portion(s) of (particularly both) side wall(s) 28 of the receptacle 21. The rear end portions of the respective terminal fittings 80 are arranged adjacent to or between the protection walls 23, thereby being laterally protected by the (both) protection wall(s) 23.

As shown in FIG. 1, the (particularly both) side wall(s) 28 of the receptacle 21 is/are recessed to form one or more, particularly a pair of mounting portions 24 into which the fixing members 60 at least partly are to be mounted. The bottom surfaces of the both mounting portions 24 particularly substantially are flat mounting surfaces 25 slightly recessed from the outer surfaces of both front and rear end portions 27F, 27R of the (both) side walls 28. Note that the rear end portions 27R particularly are arranged to be continuous with the protection walls 23. One or more steps are formed between both front and rear end edges of the mounting portions 24 of the (particularly each) side wall 28 and the both front and rear end portions 27F, 27R, and one or more, particularly a pair of mounting grooves 26 particularly are formed in these stepped parts. The respective mounting grooves 26 particularly substantially are in the form of slits which penetrate in a height direction HD (vertical direction of FIG. 1 perpendicular to forward and backward directions FBD) and are open in the front and rear surfaces of the mounting portion 24 substantially facing each other. The inner side surfaces of the respective mounting grooves 26 particularly substantially are arranged to be continuous with the mounting surface 25 without forming any step.

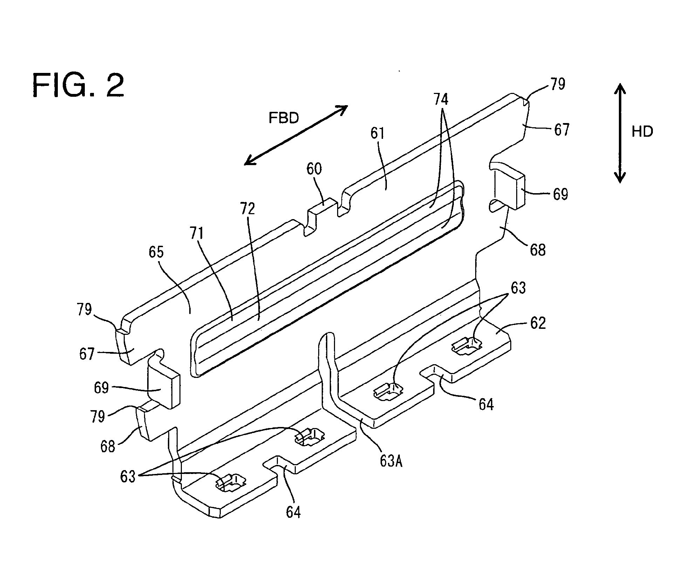

A pair of fixing members 60 are provided which are plate members particularly made of metal and/or substantially correspond to the both mounting portions 24 of the connector housing 20. As shown in FIGS. 2 to 4, each fixing member 60 particularly has a substantially L-shaped or bent cross section and is composed of or comprises a housing mounting portion 61 which extends substantially along the height direction HD and is to be at least partly mounted into the mounting portion 24, and a board mounting portion 62 which extends substantially along the width direction WD (at an angle different from 0° or 180°, preferably substantially normal to the height direction HD) and is to be mounted on or fixed to the board 90.

At least one slit 63A is so formed in at least one intermediate position (particularly substantially in a central part) of the board mounting portion 62 in forward and backward directions FBD as to extend also in a lower end portion of the housing mounting portion 61. Further, the board mounting portion 62 is formed with one or more (e.g. two) through holes 63 in the (particularly each of front and rear) area(s) divided by or adjacent to the slit 63A. Further, one or more cutout grooves 64 are formed at an outer end of the board mounting portion 62. With the board mounting portion 62 placed on the board 90, solder at least partly enters the respective through hole(s) 63 and/or the respective cutout groove(s) 64, whereby the mounting strength of the board mounting portion 62 to the board 90 is increased.

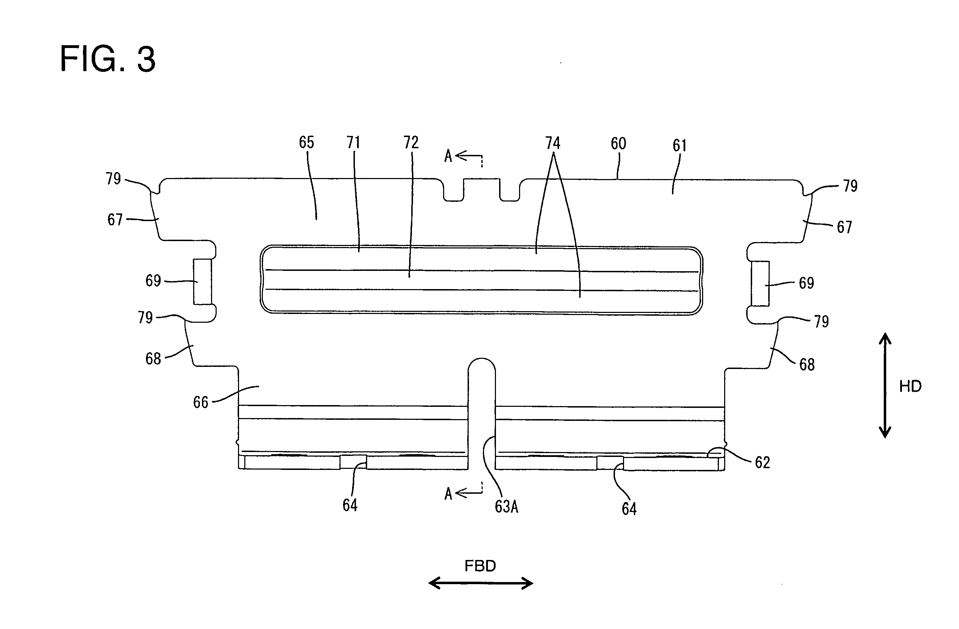

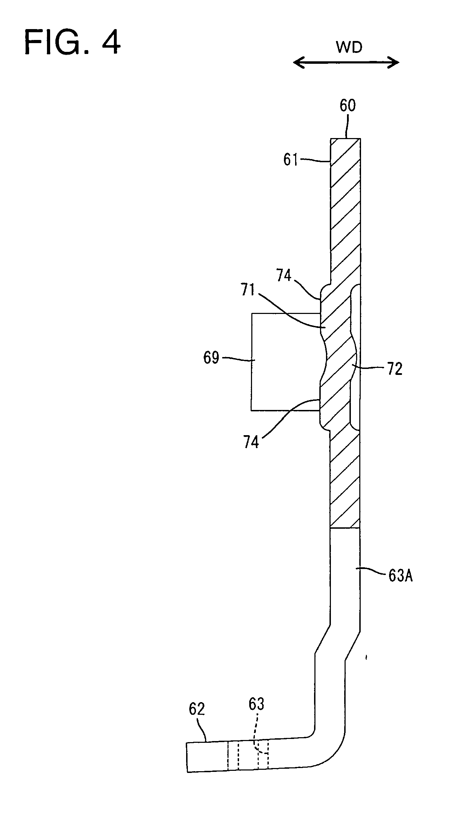

As shown in FIG. 3, the housing mounting portion 61 includes an upper level portion 65 (as a particular first portion to be arranged more distant from the board 90) particularly with a wide width in forward and backward directions FBD and a lower level portion 66 (as a particular second portion to be arranged closer to the board 90) particularly with a narrow width in forward and backward directions FBD. The upper and lower level portions 65, 66 particularly are connected via one or more steps. One or more, particularly a plurality of locking pieces 67, 68 and 69 are formed on the (particularly each of both front and rear) end edge(s) of the upper level portions 65. Out of the respective locking pieces 67, 68 and 69, those located at or near the upper end position of the upper level portion 65 are first locking pieces 67 largely projecting forward and backward, and those located at or near the lower end position of the upper level portion 65 are second locking pieces 68 projecting forward and backward less than the first locking pieces 67. Further, the locking pieces substantially in a central or intermediate part of the upper level portion 65 are third locking pieces 69 bent outward in a direction at an angle different from 0° or 180°, preferably substantially perpendicular to projecting directions of the first and second locking pieces 67, 68 (forward and backward directions FBD) as shown in FIGS. 2 and 4. As shown in FIG. 3, one or more sharp biting projections 79 particularly are so formed at the leading ends of the first and/or second locking pieces 67, 68 (particularly as to project somewhat upward). At the time of mounting the fixing member 60, the locking pieces 67, 68 and/or 69 are placed on or in correspondence with the stepped parts formed on the inner surfaces of the mounting grooves 26 of the connector housing 20 and/or the one or more biting projections 79 bite or engage into the inner surface(s) of the mounting groove(s) 26, whereby the fixing member 60 particularly is held and retained in the mounting portion 24.

As shown in FIGS. 3 and 4, the upper level portion 65 of the housing mounting portion 61 is formed at least with a first and a second ribs 71, 72 particularly substantially at the same height as the third locking pieces 69. Both first and second ribs 71, 72 horizontally extend (or in parallel with the board 90) substantially along forward and backward directions FBD. Both front and rear ends of the first and second ribs 71, 72 particularly are located at front and rear end portions of the housing mounting portion 61. The first and second ribs 71, 72 project in substantially opposite directions, the first rib 71 bulges outwardly away from the mounting surface 25 of the mounting portion 24 (particularly by hammering the upper level portion 65 of the housing mounting portion 61 to project outwardly), and the second rib 72 bulges inwardly toward the mounting surface 25 of the mounting portion 24 (particularly by hammering the upper level portion 65 of the housing mounting portion 61 to project inwardly).

Further, as shown in FIG. 3, the both first and second ribs 71, 72 are formed substantially at the same height (or at the same position along the height direction HD) particularly over the substantially entire lengths in forward and backward directions FBD. The second rib 72 is formed at a height position within the height range of the first rib 71. Specifically, the second rib 72 at least partly is formed within the formation range of the first rib 71, in other words, included in the first rib 71. More specifically, the second rib 72 particularly substantially is formed in a central part of the first rib 71 in the height direction HD, the length of the second rib 72 in forward and backward directions FBD particularly is substantially equal to that of the first rib 71 in forward and backward directions FBD and/or, as shown in FIG. 4, the projecting distance of the second rib 72 particularly is shorter than that of the first rib 71. In this case, the projecting distances of the first and/or second ribs 71, 72 particularly are so set that these ribs fit within the thickness range of the housing mounting portion 61.

Further, as shown in FIG. 4, the second rib 72 particularly has an arcuate cross-sectional shape and/or the first rib 71 particularly has a flat trapezoidal cross-sectional shape. In other words, the first and second ribs 71, 72 particularly have a different cross-sectional shape with respect to each other. The first rib 71 particularly includes one or more, particularly a pair of division beads 74 particularly on the substantially opposite upper and lower sides of the second rib 72. The both division beads 74 particularly are substantially symmetrically shaped with respect to the second rib 72.

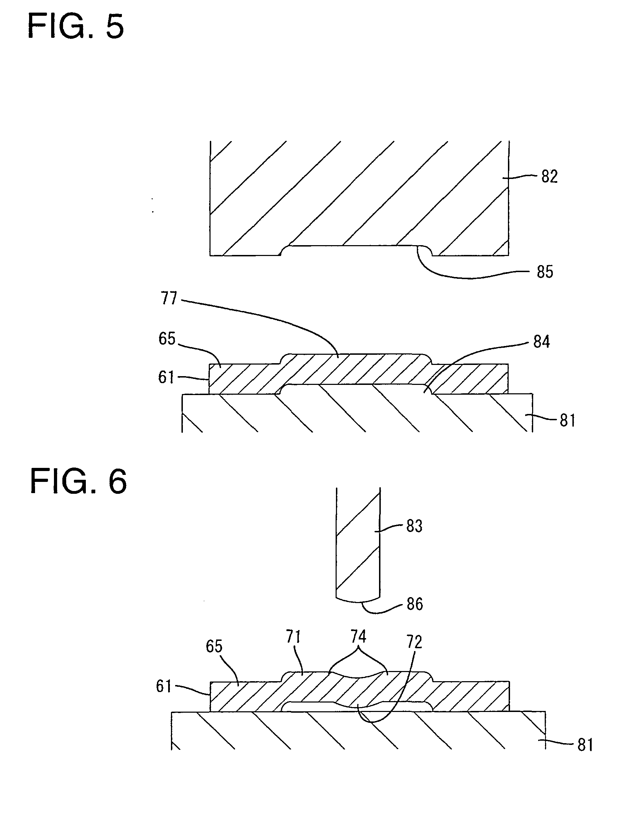

Here, in forming the first and second ribs 71, 72, a lower mold 81 (die), an upper mold 82 (punch) and a pressing mold 83 are prepared as shown in FIGS. 5 and 6. The lower mold 81 is formed with a projection 84, and the upper mold 82 is formed with a recess 85. The pressing mold 83 particularly substantially is in the form of a plate thinner than the lower mold 81 and the upper mold 82, and includes a pressing surface 86 particularly substantially having an arcuate or bent cross section on its leading end.

Next, the procedure or method of forming the first and second ribs 71, 72 is described. First, as shown in FIG. 5, the upper level portion 65 of the housing mounting portion 61 is placed on the upper surface (forming surface) of the projection 84 of the lower mold 81 and, in this state, the upper mold 82 is lowered (or the molds 81, 82 is/are displaced with respect to each other) to form a first rib body 77 between the recess 85 of the upper mold 82 and the projection 84 of the lower mold 81 and the upper mold 82 is raised to be retracted from the first rib body 77. Thereafter, the pressing mold 83 is lowered to press the pressing surface 86 of the pressing mold 83 into contact with a central or intermediate part of the first rib body 77 in the height direction from above. Then, as shown in FIG. 6, the outer surface of the central or intermediate part of the first rib body 77 in the height direction is curved and deformed along the pressing surface 86 of the pressing mold 83, whereby the both division beads 74 (first rib 71) and the second rib 72 are formed.

Next, the procedure of mounting the board connector 10 on the board 90 and the like are described.

First, the one or more terminal fittings 80 are mounted into the one or more respective terminal mounting holes 22 of the connector housing 20 and the one or more fixing members 60 are mounted into the (particularly both) mounting portion(s) 24 of the connector housing 20. At this time, the front and/or rear end portions of the housing mounting portions 61 at least partly are inserted into the front and/or rear mounting grooves 26 at the (particularly both) side wall(s) 28 of the connector housing 20 from above, and the fixing member(s) 60 is/are held and retained in the mounting portion(s) 24 of the connector housing 20 particularly by the locking action of the locking piece(s) 67, 68 and/or 69 and/or the biting projection(s) 79.

Subsequently, as shown in FIG. 1, the connector housing 20 is placed on the surface of the board 90 and the board contact portion(s) 81 of the respective terminal fitting(s) 80 is/are connected to the conductive portion(s) of the board 90 particularly by soldering (such as reflow-soldering). Further, the board mounting portion(s) 62 of the (particularly both) fixing member(s) 60 is/are connected to the board 90 at least partly by soldering (such as reflow-soldering). At this time, the front end portion of the receptacle 21 of the board connector 10 is arranged to substantially project forward from or at the front end edge of the board 90. Further, the unillustrated mating connector is or can be at least partly fitted into the receptacle 21 of the connector housing 20 from front to electrically connect the corresponding mating terminal fittings to the respective terminal fittings 80.

In the above case, if a force acts in a direction to tear or shift the board connector 10 from the board 90, for example, because an unillustrated wire drawn out from the mating connector is pulled upward, the housing mounting portions 61 of the fixing members 60 may be plastically deformed to reduce engagement margins with the mounting grooves 26. However, since the rigidity of the housing mounting portions 61 is increased by the first and second ribs 71, 72 according to this embodiment, the housing mounting portions 61 are not easily deformed and the engagement margins between the housing mounting portions 61 and the mounting grooves 26 are satisfactorily maintained. Thus, reliability in holding the fixing members 60 onto the connector housing 20 is improved.

Further, since the second rib 72 particularly is arranged to fit within the height range of the first rib 71 with respect to the height direction HD at an angle different from 0° or 180°, preferably substantially perpendicular to the forward and backward directions FBD, the enlargement of the housing mounting portion 61 in the height direction HD is prevented and/or the space efficiency of the housing mounting portion 61 and consequently the fixing member 60 is improved. In addition, since the second rib 72 particularly is formed within the formation range of the first rib 71 and/or the first and second ribs 71, 72 project in substantially opposite directions, the enlargement of the housing mounting portion 61 in the projecting direction of the first rib 71 (thickness direction of the housing mounting portion 61) is prevented.

Furthermore, since the first rib 71 particularly projects substantially outwardly away from the mounting surface 25 of the mounting portion 24, the second rib 72 particularly projects substantially inwardly toward the mounting surface 25 of the mounting portion 24 and/or the second rib 72 particularly is arranged to fit within the projecting distance of the first rib 71, the interference of the first and second ribs 71, 72 with the connector housing 20 is avoided even without providing the mounting surface 25 of the mounting portion 24 with a recess or the like for allowing the first and second ribs 71, 72 to escape.

Further, since the second rib 72 particularly is formed in the central or intermediate part of the first rib 71 in the height direction HD, the both first and second ribs 71, 72 are excellent in shape stability.

Accordingly, to provide a board connector including a fixing member having high holding reliability and good space efficiency, a board connector 10 includes a connector housing 20 which particularly is made of resin and in which one or more terminal fittings 80 connectable to one or more respective conductive portions of a board 90 are to be mounted, and one or more fixing members 60 (which particularly are made of metal) and fix the connector housing 20 to the board 90. The (particularly each) fixing member 60 includes a housing mounting portion 61 to be mounted on a wall surface of the connector housing 20 and both front and rear end portions of the housing mounting portion 61 are at least partly inserted and held in mounting grooves 26 formed in the wall surface of the connector housing 20. The housing mounting portion 61 is at least partly formed with at least one first rib 71 projecting while extending in forward and backward directions FBD, and at least one second rib 72 extending in forward and backward directions FBD and arranged to fit within the height range of the first rib 71 with respect to a height direction HD at an angle different from 0° or 180°, preferably substantially perpendicular to forward and backward directions FBD.

### <Other Embodiments>

The present invention is not limited to the above described and illustrated embodiment. For example, the following embodiments are also included in the technical scope of the present invention.
(1) Although the second rib is located at such a position as to fit within the height range of the first rib, it may be arranged before or behind the first rib.
(2) The first and second ribs may project in the substantially same direction.
(3) The first and second ribs may be arranged in a central part or a lower part (lower level portion) of the housing mounting portion in the height direction HD.
(4) The lengths of the first and second ribs in forward and backward directions FBD are arbitrary and may be shorter than those of the above embodiment depending on the situation.
(5) Contrary to the above embodiment, the first rib may have an arcuate cross-sectional shape and the second rib may have a trapezoidal cross-sectional shape.
(6) The fixing members may be screwed or riveted or fixed in any other way to the board.

### LIST OF REFERENCE SIGNS

- 10: board connector
- 20: connector housing
- 26: mounting groove
- 60: fixing member
- 61: housing mounting portion
- 62: board mounting portion
- 71: first rib
- 72: second rib
- 80: terminal fitting
- 90: board

## Claims

1. A board connector (10), comprising:
a connector housing (20) in which one or more terminal fittings (80) connectable to one or more respective conductive portions of a board (90) are to be mounted; and
at least one fixing member (60) is to fix the connector housing (20) to the board (90);
wherein:
the fixing member (60) includes a housing mounting portion (61) to be mounted on a wall surface (28) of the connector housing (20); and
the housing mounting portion (61) is formed with at least one first rib (71) and at least one second rib (72) respectively projecting while extending in forward and backwards directions (FBD) and the second rib (72) is arranged to fit within the height range of the first rib (71) with respect to a height direction (HD) perpendicular to forward and backward directions (FBD), wherein the first and second ribs (71, 72) respectively project in opposite directions.

2. A board connector according to claim 1, wherein the connector housing (20) is made of resin and/or wherein the at least one fixing member (60) is made of metal.

3. A board connector according to any one of the preceding claims, wherein both front and rear end portions of the housing mounting portion (61) are at leat partly inserted and held in mounting grooves (26) formed in the wall surface (28) of the connector housing (20).

4. A board connector according to any one of the preceding claims, wherein the second rib (72) is formed included in the first rib (71).

5. A board connector according to claim 1, wherein:
the first rib (71) projects outwardly away from the wall surface (28) of the connector housing (20), the second rib (72) projects inwardly toward the wall surface (28) of the connector housing (20).

6. A board connector according to any one of the preceding claims, wherein the second rib (72) is arranged to fit within the projecting distance of the first rib (71).

7. A board connector according to any one of the preceding claims, wherein the second rib (72) is formed in a central part of the first rib (71) in the height direction (HD).

8. A board connector according to any one of the preceding claims, wherein a length of the second rib (72) in forward and backward directions (FBD) is substantially equal to that of the first rib (71) in forward and backward directions (FBD) and/or wherein a projecting distance of the second rib (72) is shorter than that of the first rib (71).

9. A board connector according to any one of the preceding claims, wherein the first rib (71) includes one or more division beads (74) adjacent to the second rib (72), particularly on the substantially opposite sides of the second rib (72).

10. A board connector according to claim 9, wherein the both division beads (74) are substantially symmetrically shaped with respect to the second rib (72).

11. A board connector according to any one of the preceding claims, wherein the fixing member (60) comprises a board mounting portion (82) to be mounted onto the board (90), wherein at least one slit (63A) is so formed in at least one intermediate position of the board mounting portion (62) in forward and backward directions (FBD), particularly so as to extend also in a lower end portion of the housing mounting portion (61), and/or wherein the board mounting portion (62) is formed with one or more through holes (63) and/or one or more cutout grooves (64), particularly so that with the board mounting portion (62) placed on the board (90), solder can at least partly enter the respective through hole(s) (63) and/or the respecive cutout groove(s) (64).

12. A board connector according to any one of the preceding claims, wherein the fixing member (60) comprises one or more locking pieces (67; 68; 69) and/or one or more sharp biting projections (79)so as to fixedly mount the fixinf member (60) to the connector housing (20).

13. A method of producing a fixing member (60) for fixing a board connector (10) to a board (90), comprising the following steps:
shaping a metal blank so as to form a housing mounting portion (61) on a forming surface of a projection (84) of a first mold (81),
placing a portion (65) of the housing mounting portion (61) on a forming surface of a projection (84) of a first mold (81),
relatively moving the first mold (81) and a second mold (82) to form a first rib body (77) of a first rib (71) between a recess (85) of the second mold (82) and the projection (84) of the first mold (81),
relatively moving the first and second molds (81, 82) to retract the first rib body (77) from the second mold (82),
lowering a pressing mold (83) to press a pressing surface (86) of the pressing mold (83) into contact with at least one central or intermediate part of the first rib body (77) so as to curve and deform an outer surface of the central or intermediate part of the fist rib body (77) along the pressing surface (86) of the pressing mold (83), whereby at least the first rib (71) and a second rib (72) being arranged to fit within the height range of the first rib (71) with respect to a height direction (HD) are formed, wherein the first and second ribs (71, 72) respectively project in opposite directions.

14. A method according to claim 13, wherein the first rib (71) is formed with one or more division beads (74) adjacent to the second rib (72), particularly on the substantially opposite sides of the second rib (72).

15. A method according to claim 14, wherein when the outer surface of the central or intermediate part of the first rib body (77) is curved and deformed along the pressing surface (86) of the pressing mold (83), the both division beads (74) of the first rib (71) are formed.

## Patentansprüche

1. Ein Leiterplattensteckverbinder (10), der Folgendes umfasst:
ein Steckverbindergehäuse (20), in das ein oder mehrere Anschlussstücke (80), die mit einem oder mehreren entsprechenden leitenden Abschnitten der Leiterplatte (90) verbindbar sind, zu montieren sind; und
mindestens ein Befestigungselement (60) die Aufgabe hat, das Steckverbindergehäuse (20) mit der Leiterplatte (90) zu fixieren;
wobei:
das Befestigungselement (60) einen Abschnitt (61) zur Gehäusemontage beinhaltet, das an einer Wandoberfläche (28) des Steckverbindergehäuses (20) zu montieren ist; und
der Abschnitt (61) zur Gehäusemontage mit mindestens einer ersten Rippe (71) und mindestens einer zweiten Rippe (72) gebildet wird, die jeweils vorstehen, während sie sich in Vorwärts- und in Rückwärts-Richtung (FBD) erstrecken, und wobei die zweite Rippe (72) angeordnet ist, um in den Höhenbereich der ersten Rippe (71) in Höhenrichtung (HD) zu passen, die zur Vorwärts- und in Rückwärts-Richtung (FBD) senkrecht steht, wobei die erste und die zweite Rippe (71, 72) jeweils in entgegengesetzte Richtungen vorstehen.

2. Ein Leiterplattensteckverbinder nach Anspruch 1, wobei das Steckverbindergehäuse (20) aus Harz hergestellt wird und/oder wobei das mindestens eine Befestigungselement (60) aus Metall hergestellt wird.

3. Ein Leiterplattensteckverbinder nach einem der vorhergehenden Ansprüche, wobei beide Endabschnitte, der vordere und der hintere, des Abschnitts (61) zur Gehäusemontage zumindest teilweise in Montagenuten (26) eingesteckt und dort gehalten werden, die in der Wandoberfläche (28) des Steckverbindergehäuses (20) gebildet sind.

4. Ein Leiterplattensteckverbinder nach einem der vorhergehenden Ansprüche, wobei die zweite Rippe (72) als in der ersten Rippe (71) enthalten gebildet wird.

5. Ein Leiterplattensteckverbinder nach Anspruch 1, wobei:
die erste Rippe (71) nach außen, von der Wandoberfläche (28) des Steckverbindergehäuses (20) wegführend, vorsteht, wobei die zweite Rippe (72) nach innen, zur Wandoberfläche (28) des Steckverbindergehäuses (20) hinführend, vorsteht.

6. Ein Leiterplattensteckverbinder nach einem der vorhergehenden Ansprüche, wobei die zweite Rippe (72) angeordnet ist, um in den vorragenden Abstand der ersten Rippe (71) zu passen.

7. Ein Leiterplattensteckverbinder nach einem der vorhergehenden Ansprüche, wobei die zweite Rippe (72), bezüglich der Höhenrichtung (HD), in einem zentralen Teil der ersten Rippe (71) gebildet wird.

8. Ein Leiterplattensteckverbinder nach einem der vorhergehenden Ansprüche, wobei eine Länge der zweiten Rippe (72) in Vorwärts- und in Rückwärts-Richtung (FBD) im Wesentlichen der Länge der ersten Rippe (71) in Vorwärts- und in Rückwärts-Richtung (FBD) entspricht und/oder wobei ein vorragender Abstand der zweiten Rippe (72) kürzer als der vorragende Abstand der ersten Rippe (71) ist.

9. Ein Leiterplattensteckverbinder nach einem der vorhergehenden Ansprüche, wobei die erste Rippe (71) eine oder mehrere Trenn-Verstärkungsrippen (74) beinhaltet, die an der zweiten Rippe (72), insbesondere an im Wesentlichen entgegengesetzten Seiten der zweiten Rippe (72) anliegen.

10. Ein Leiterplattensteckverbinder nach Anspruch 9, wobei beide Trenn-Verstärkungsrippen (74) bezüglich der zweiten Rippe (72) im Wesentlichen symmetrisch geformt sind.

11. Ein Leiterplattensteckverbinder nach einem der vorhergehenden Ansprüche, wobei das Befestigungselement (60) einen Leiterplattenmontageabschnitt (82) umfasst, der auf der Leiterplatte (90) zu montieren ist, wobei mindestens ein Schlitz (63A) in mindestens einer mittleren Position des Leiterplattenmontageabschnitts (62) in Vorwärts- und in Rückwärts-Richtung (FBD) derart gebildet wird, dass er insbesondere ebenso in einem unteren Endabschnitt des Gehäusemontage-Abschnitts (61) verläuft, und/oder wobei der Leiterplattenmontageabschnitt (62) mit einem oder mehreren Durchgangslöchern (63) und/oder mit einem oder mehreren Ausschnittsnuten (64) insbesondere derart gebildet wird, dass, wenn der Leiterplattenmontageabschnitt (62) auf der Leiterplatte (90) angeordnet ist, Lötmittel zumindest zum Teil in die entsprechenden Durchgangslöcher (63) und/oder in die entsprechende(n) Ausschnittsnut(en) (64) eintreten kann.

12. Ein Leiterplattensteckverbinder nach einem der vorhergehenden Ansprüche, wobei das Befestigungselement (60) ein oder mehrere Sperrstücke (67; 68; 69) und/oder einen oder mehrere scharf eingreifende Vorsprünge (79) umfasst, sodass das Befestigungselement (60) am Steckverbindergehäuse (20) fest montiert wird.

13. Ein Verfahren zur Herstellung eines Befestigungselements (60), um einen Leiterplattensteckverbinder (10) an einer Leiterplatte (90) zu befestigen, das die folgenden Schritte umfasst:
formen eines Metallrohlings, sodass ein Gehäusemontage-Abschnitt (61) auf der Formfläche eines Vorsprungs (84) einer ersten Form (81) gebildet wird,
anordnen eines Abschnitts (65) des Gehäusemontage-Abschnitts (61) auf die Formfläche eines Vorsprungs (84) einer ersten Form (81),
relativ bewegen der ersten Form (81) und einer zweiten Form (82) zur Bildung eines ersten Rippenkörpers (77) einer ersten Rippe (71) zwischen einem Rücksprung (85) der zweiten Form (82) und dem Vorsprung (84) der ersten Form (81),
relativ bewegen der ersten und der zweiten Form (81, 82) zum Zurückziehen des ersten Rippenkörpers (77) aus der zweiten Form (82),
absenken einer Pressform (83), um eine Pressfläche (86) der Pressform (83) in Kontakt mit mindestens einem zentralen oder zwischenliegenden Teil des ersten Rippenkörpers (77) anzupressen, sodass eine Außenfläche des zentralen oder zwischenliegenden Teils des ersten Rippenkörpers (77) entlang der Pressfläche (86) der Pressform (83) gebogen oder verformt wird, wobei zumindest die erste Rippe (71) und eine zweite Rippe (72), die derart angeordnet ist, dass sie in den Höhenbereich der ersten Rippe (71) in Höhenrichtung (HD) passt, gebildet werden, wobei die erste und die zweite Rippe (71, 72) jeweils in entgegengesetzte Richtungen vorstehen.

14. Ein Verfahren nach Anspruch 13, wobei die erste Rippe (71) mit einer oder mit mehreren Trenn-Verstärkungsrippen (74) gebildet wird, die an der zweiten Rippe (72), insbesondere an im Wesentlichen entgegengesetzten Seiten der zweiten Rippe (72) anliegen.

15. Ein Verfahren nach Anspruch 14, wobei, wenn die Außenfläche des zentralen oder zwischenliegenden Teils des ersten Rippenkörpers (77) entlang der Pressfläche (86) der Pressform (83) gebogen oder verformt wird, die beiden Trenn-Verstärkungsrippen (74) der ersten Rippe (71) gebildet werden.

## Revendications

1. Un connecteur de carte (10), comprenant:
un boîtier de connecteur (20) dans lequel un ou plusieurs raccords de borne (80), pouvant être connectés à une ou plusieurs respectives portions conductrices d'une carte (90), sont à monter ; et
au moins un élément de fixation (60) est en mesure de fixer le boîtier de connecteur (20) à la carte (90) ;
sachant que :
l'élément de fixation (60) inclut une portion de montage de boîtier (61) à monter sur une surface de paroi (28) du boîtier de connecteur (20) ; et que
la portion de montage de boîtier (61) est formée avec au moins une première nervure (71) et au moins une deuxième nervure (72) saillant respectivement tout en s'étendant dans des directions avant et arrière (FBD) ; et sachant que la deuxième nervure (72) est disposée de manière à tenir dans la plage de hauteur de la première nervure (71) dans la direction de la hauteur (HD) perpendiculaire à la direction avant et arrière (FBD), sachant que la première et la deuxième nervure (71, 72) saillent respectivement dans des directions opposées.

2. Un connecteur de carte d'après la revendication 1, sachant que le boîtier de connecteur (20) est réalisé en résine et/ou sachant que le ou les éléments de fixation (60) sont réalisés en métal.

3. Un connecteur de carte d'après une des revendications précédentes, sachant que les deux portions terminales avant et arrière de la portion de montage de boîtier (61) sont insérées au moins en partie et maintenues dans des rainures de montage (26) formées dans la surface de paroi (28) du boîtier de connecteur (20).

4. Un connecteur de carte d'après une des revendications précédentes, sachant que la deuxième nervure (72) est formée de manière inclue dans la première nervure (71).

5. Un connecteur de carte d'après la revendication 1, sachant que :
la première nervure (71) saille vers l'extérieur en s'éloignant de la portion de paroi (28) du boîtier de connecteur (20), et que la deuxième nervure (72) saille vers l'intérieur vers la portion de paroi (28) du boîtier de connecteur (20).

6. Un connecteur de carte d'après une des revendications précédentes, sachant que la deuxième nervure (72) est disposée de manière à tenir dans la distance de saillie de la première nervure (71).

7. Un connecteur de carte d'après une des revendications précédentes, sachant que la deuxième nervure (72) est formée dans une partie centrale de la première nervure (71) en direction de la hauteur (HD).

8. Un connecteur de carte d'après une des revendications précédentes, sachant qu'une longueur de la deuxième nervure (72) dans des directions avant et arrière (FBD) est essentiellement égale à celle de la première nervure (71) dans des directions avant et arrière (FBD) et/ou sachant qu'une distance de saillie de la deuxième nervure (72) est plus courte que celle de la première nervure (71).

9. Un connecteur de carte d'après une des revendications précédentes, sachant que la première nervure (71) inclut un ou plusieurs bourrelets de séparation (*division beads*) (74) adjacents à la deuxième nervure (72), notamment sur les côtés essentiellement opposés de la deuxième nervure (72).

10. Un connecteur de carte d'après la revendication 9, sachant que les deux bourrelets de séparation (74) présentent une forme essentiellement symétrique par rapport à la deuxième nervure (72).

11. Un connecteur de carte d'après une des revendications précédentes, sachant que l'élément de fixation (60) comprend une portion de montage de carte (82) à monter sur la carte (90), sachant qu'au moins une fente (63A) est formée dans au moins une position intermédiaire de la portion de montage de carte (62) dans des directions avant et arrière (FBD), de façon notamment à s'étendre également dans une position terminale inférieure de la portion de montage de boîtier (61), et/ou sachant que la portion de montage de carte (62) est formée avec un ou plusieurs trous traversants (63) et/ou avec une ou plusieurs rainures découpées (64), notamment de manière que, la portion de montage de carte (62) étant placée sur la carte (90), du métal d'apport de brasage peut au moins partiellement entrer dans le ou les trous traversants (63) respectifs et/ou dans la ou les rainures découpées (64) respectives.

12. Un connecteur de carte d'après une des revendications précédentes, sachant que l'élément de fixation (60) comprend une ou plusieurs pièces de verrouillage (67 ; 68 ; 69) et/ou une ou plusieurs parties saillantes tranchantes (*sharp and biting*) (79) pour un montage fixe de l'élément de fixation (60) auprès du boîtier de connecteur (20).

13. Un procédé de production d'élément de fixation (60) pour fixer un connecteur de carte (10) sur une carte (90), comprenant les étapes suivantes :
façonner une ébauche métallique de manière à former une portion de montage de boîtier (61) sur une surface de formation d'une saillie (84) d'un premier moule (81),
placer une partie (65) de la portion de montage de boîtier (61) sur une surface de formation d'une saillie (84) d'un premier moule (81),
déplacer relativement le premier moule (81) par rapport à un deuxième moule (82) pour former un premier corps de nervure (77) d'une première nervure (71) entre un renfoncement (85) du deuxième moule (82) et la saillie (84) du premier moule (81),
déplacer relativement le premier et le deuxième moule (81, 82) pour rétracter le premier corps de nervure (77) du deuxième moule (82),
abaisser un moule de pression (83) pour effectuer une pression sur une surface de pressage (86) du moule de pression (83) pour qu'elle vienne en contact avec au moins une partie centrale ou intermédiaire du premier corps de nervure (77), pour qu'une surface extérieure de la partie centrale ou intermédiaire du premier corps de nervure (77) soit courbée ou déformée le long d'une surface de pressage (86) du moule de pression (83), sachant qu'au moins la première nervure (71) et une deuxième nervure (72), agencée de manière à tenir dans la plage de hauteur de la première nervure (71) dans une direction de hauteur (HD), sont formées, sachant que la première et la deuxième nervure (71, 72) saillent respectivement dans des directions opposées.

14. Un procédé d'après la revendication 13, sachant que la première nervure (71) est formée avec un ou plusieurs bourrelets de séparation (*division beads*) (74) adjacents à la deuxième nervure (72), notamment sur les côtés essentiellement opposés de la deuxième nervure (72).

15. Un procédé d'après la revendication 14, sachant que, quand la surface extérieure de la partie centrale ou intermédiaire du premier corps de nervure (77) est courbée ou déformée le long de la surface de pressage (86) du moule de pression (83), les deux bourrelets de séparation (74) de la première nervure (71) sont constitués.
